# EUROPEAN PATENT APPLICATION

(11) **EP 1 032 250 A2**
(43) Date of publication of application: **30.08.2000**
(21) Application number: 00301000.6
(22) Date of filing: 09.02.2000
(51) Int. Cl.: H05K 7/20

(54) **Cable and heat sink**

(30) Priority: 25.02.1999 JP 4764399
(71) Applicant: International Business Machines Corporation, Armonk, NY 10504 (US)
(72) Inventor: Ishii, Shigeru, IBM United Kington Ltd., I.P.L., Winchester, Hampshire S021 2JN (GB); Mori, Shigeki, IBM United Kington Ltd., I.P.L., Winchester, Hampshire S021 2JN (GB); Nishimura, Hirokazu, IBM U.K. Ltd., I.P.L., Winchester, Hampshire S021 2JN (GB); Nakai, Shinji, IBM U.K. Ltd., I.P.L., Winchester, Hampshire S021 2JN (GB)
(74) Representative: Moss, Robert Douglas

(57) **Abstract**

A cable to radiate heat generated inside a wearable computer. Heat generated by a CPU inside a PC body is transferred to a heat conducting member and is further transferred to a heat conducting sheet of a cable via a heat pipe and a connection member. The heat conducting sheet conducts in the longitudinal direction of the cable the heat transferred via the heat collecting member, the heat pipe, and the connection member while gradually releasing the heat to the exterior thereof via the coating to radiate the heat from the interior of the PC body.

## Description

The present invention relates to a cable capable of radiating heat, and in particular, to a cable that is connected to, for example, a portable computer to transmit image signals displayed to users and to conduct heat generated inside the portable computer to its exterior for heat radiation.

The present invention also relates to a heat sink using the cable capable of radiating heat, and in particular, to a heat sink that radiates heat by conducting heat to the cable capable of radiating heat from a CPU in a portable computer, which is a heat generator from which heat cannot be radiated easily and to which a radiator cannot be attached easily.

For example, "Nikkei Electronics 11 Jan. pp. 83 to 95 (Nikkei BP Co., Ltd., published on 11 Jan. 1999, No. 734)" discloses a small computer that is conveniently portable (so-called "wearable computer")

The body of the wearable computer has a small external shape, for example, 190mm x 63mm x 117mm (in the above document, p. 90), and such a computer is fixed to a user's belt for operation to realize a high mathematical performance.

In addition, the wearable computer has, for example, a display device connected to the body of the wearable computer via a cable and mounted on the user's head and an input device that can be operated one-handed.

As described above, the wearable computer is configured to have a very small body, and it is difficult to externally attach a radiator to the wearable computer due to its installation on the user's body (clothes).

On the other hand, since a high mathematical performance is required of the wearable computer, the reduction of the heating value is limited that is attempted by maintaining a lower clock frequency. Thus, the heat radiation design of the wearable computer is very difficult.

For example, Published Unexamined Japanese Patent Application No. 09-288913 discloses a flat cable for power including recesses and projections on its sides to radiate heat from the cable.

This flat cable effectively radiates heat from itself, but cannot be used for an application in which heat is allowed to escape to the exterior from a device to which the flat cable is connected.

The present invention accordingly provides, in a first aspect, a cable capable of radiating heat, comprising: a heat conducting and radiating member for conducting heat in the longitudinal direction of said cable and radiating the conducted heat.

A cable according to the first aspect preferably comprises: conductors extending in the longitudinal direction of said cable, wherein; said heat conducting and radiating member extends in the longitudinal direction of said cable and disposed along said conductors.

A cable according to the first aspect is preferably one wherein said conductor is a transmission line that transmits signals or power.

In a second aspect, the present invention provides a cable capable of radiating heat comprising: conductors extending in the longitudinal direction of said cable; a heat conducting and radiating member covering the circumference of said conductors to conduct heat in the longitudinal direction of said cable and to radiate the conducted heat; and a coating covering the circumference of said heat conducting and radiating member.

In a third aspect, the present invention provides a heat sink comprising: a cable capable of radiating heat; and a heat connecting member for thermally connecting a heat generator to said cable capable of radiating heat.

In a heat sink of the third aspect, said cable preferably comprises: conductors extending in the longitudinal direction of said cable; a heat conducting and radiating member covering the circumference of said conductors to conduct heat in the longitudinal direction of said cable and to radiate the conducted heat; and a coating covering the circumference of said heat conducting and radiating member.

In a heat sink according to the third aspect, said cable preferably comprises: a heat conducting and radiating member for conducting heat in the longitudinal direction of said cable and radiating the conducted heat.

In a heat sink according to the third aspect, said heat connecting member preferably conducts heat from said heat generator to said heat conducting and radiating member of said cable.

A heat sink of the third aspect preferably comprises conductors extending in the longitudinal direction of said cable, wherein said heat conducting and radiating member extends in the longitudinal direction of said cable and is disposed along said conductors.

In a heat sink of the third aspect, said conductor is preferably a transmission line that transmits signals or power.

The present invention thus provides a cable capable of conducting heat generated inside a connected device to the exterior for heat radiation.

The invention preferably provides a heat sink capable of using a cable connected to a device to which a radiating means cannot be attached easily in order to conduct heat generated inside this device to the exterior for heat radiation.

The invention preferably provides a cable and heat sink wherein a heat conducting member is added to a cable connecting the body of a portable computer such as a wearable computer to a display device and wherein the cable with the heat conducting member added thereto is used to radiate heat from the interior of the portable computer body.

Thus, a first cable according to this invention is preferably a cable capable of radiating heat, comprising a heat conducting and radiating member for conducting heat in the longitudinal direction of the cable and radiating the conducted heat.

Preferably, the cable comprises conductors extending in the longitudinal direction of the cable, and the heat conducting and radiating member extends in the longitudinal direction of the cable and disposed along the conductors.

Preferably, the conductor is a transmission line that transmits signals or power.

Further preferably, a second cable according to this invention is a cable capable of radiating heat comprising conductors extending in the longitudinal direction of the cable, a heat conducting and radiating member covering the circumference of the conductors to conduct heat in the longitudinal direction of the cable and to radiate the conducted heat, and a coating covering the circumference of the heat conducting and radiating member.

The cable according to this invention, for example, preferably connects the body of a wearable computer and its display device together and conducts to the exterior, heat generated by a CPU in the body of the wearable computer to release the conducted heat to the exterior from the surface in order to radiate heat from the interior of the body.

In a preferred cable according to this invention, the heat conducting and radiating member is, for example, a heat conducting sheet wound between signal lines and a coating of the cable to conduct, in the longitudinal direction of the cable, heat generated by the CPU in the computer body in order to gradually radiate heat from the surface of the cable.

In addition, a heat sink according to this invention preferably comprises a cable capable of radiating heat, and a heat connecting member for thermally connecting a heat generator to the cable capable of radiating heat.

A heat sink according to this invention preferably uses the above cable according to this invention to, for example, conduct heat generated by the CPU inside the computer body, to the exterior for heat radiation.

The preferred heat connecting means comprises, for example, a heat pipe for thermally connecting together the CPU inside the wearable computer and the heat conducting and radiating member (the above heat conducting sheet) of the cable according to this invention used as a cable for connections to a display device. The heat connecting means preferably conducts heat generated by the CPU to the heat conducting sheet of the cable in order to help to radiate the beat generated by the CPU to the exterior.

A preferred embodiment of the present invention will now be described, by way of example only, with reference to the accompanying drawings in which:
Figure 1 shows a configuration of a wearable computer to which a cable and heat sink according to this invention is applied;
Figure 2 shows a configuration of the cable shown in Figure 1;
Figure 3 is a sectional view of the cable shown in Figures 1 and 2;
Figure 4 shows a connection between a PC body and a cable;
Figure 5 shows a connection between the cable and a connection member, which is shown by circle (a) in Figure 4;
Figure 6 shows a connection between a CPU and a heat collecting member, which is shown by circle (b) in Figure 4; and
Figure 7 is heat radiation effected by the cable according to this invention.

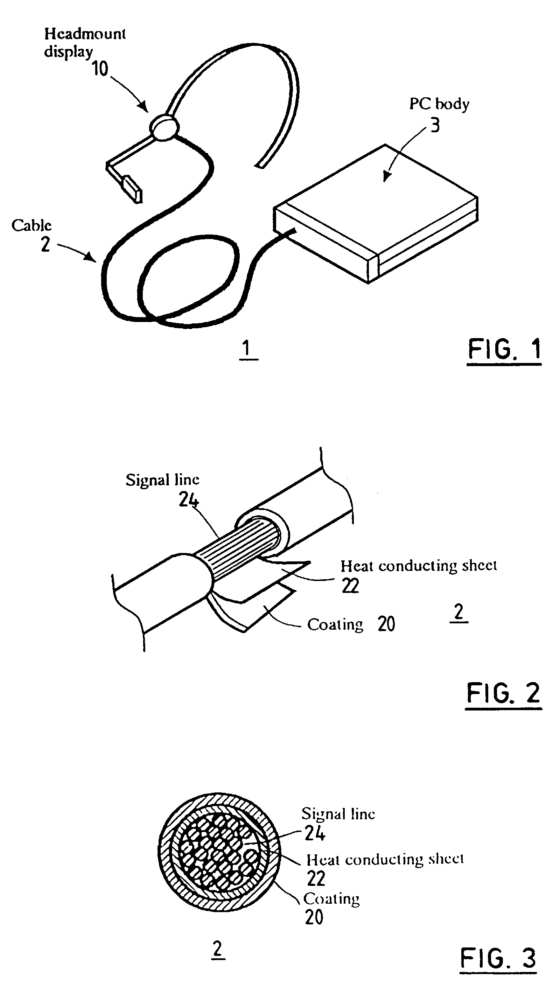

First, Figure 1 is referenced to describe a wearable computer 1 to which a cable and heat sink according to this invention is applied.

Figure 1 illustrates a configuration of the wearable computer 1 to which the cable and heat sink according to this invention is applied.

As shown in this figure, the wearable computer 1 comprises a headmount display 10, a cable 2, and the body (PC body) 3 of the wearable computer.

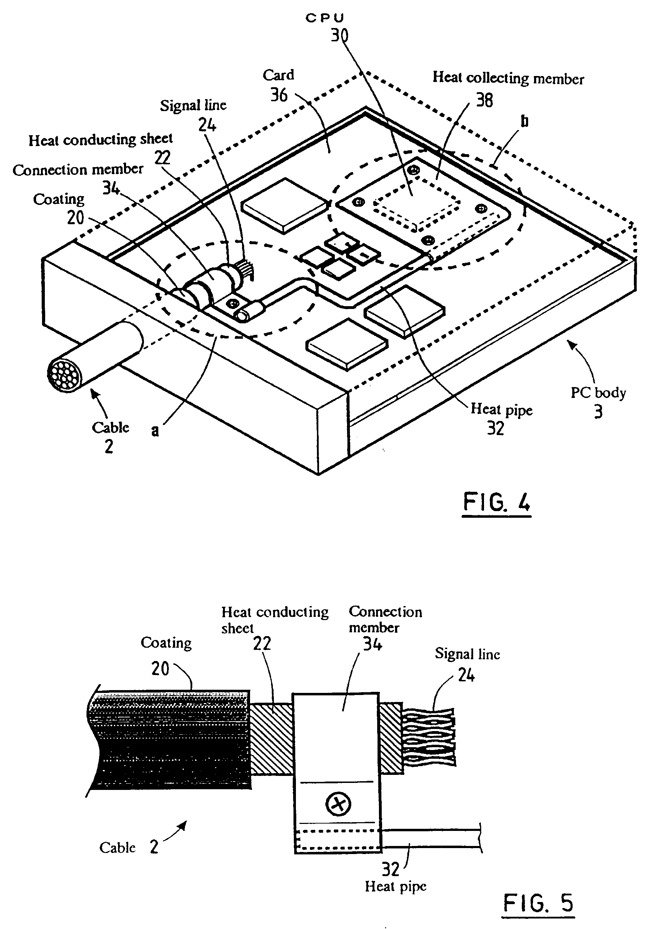

In the wearable computer 1, the cable 2 according to this invention connects together the PC body 3 and the headmount display 10 mounted on the user's head to transmit an operating power and image signals from the PC body 3 to the headmount display 10 while conducting heat generated by a CPU 30 (that will be described in detail with reference to Figure 4) inside the PC body 3 to the exterior of the PC body 3 to release it from the surface, thereby radiating heat from the interior of the PC body 3.

As described below, besides the configuration of the cable 2 as a signal and power cable for transmitting signals and power, the cable 2 can be configured, for example, as a power or signal cable for transmitting power or signals, or as a loss prevention rope that does not have power or signal lines and that simply connects the headmount display 10 and the PC body 3 together. For simple description and easy understanding, the following description explains a specific example in which the cable 2 is configured as a signal cable as described above, unless otherwise stated.

A configuration of the cable 2 will be described below.

Figure 2 shows a configuration of the cable 2 shown in Figure 1.

Figure 3 is a sectional view of the cable 2 shown in Figures 1 and 2.

As shown in Figures 2 and 3, the cable 2 extends in the longitudinal direction of the cable 2 and is composed of conductors 24 transmitting an operating power and image signals from the PC body 3 to the headmount display 10, a heat conducting sheet 22 provided along the conductors 24 so as to cover their circumference, and a coating 24 provided so as to cover the conductors 24 and the heat conducting sheet 22 in order to protect the interior of the cable 2.

That is, the cable 2 is configured to have the heat conducting sheet 22 between the conductors 24 and coating 20 of a normal signal cable.

The heat conducting sheet 22 is composed of a material having a high heat conductivity and flexibility, for example, the product of Matsushita Electric Industrial Co., Ltd. "Panasonic Graphite Sheet". The heat conducting sheet 22 conducts in the longitudinal direction of the cable 2, heat generated by the CPU 30 inside the PC body 3 while gradually releasing the heat from the surface of the cable 2 in order to radiate it from the PC body 3.

The properties that should be provided for the heat conducting sheet 22 include a high conductivity, a high flexibility, and a high durability.

Of these properties, the high heat conductivity is required to radiate heat from the PC body 3.

In addition, due to the connection between the PC body 3 and the headmount display 10, the usability of the wearable computer 1 may be degraded if the cable 2 lacks flexibility. Thus, the heat conducting sheet 22 must be very flexible for the same reason as in the cable 2.

Likewise, the heat conducting sheet 22 is repeatedly folded prior to use, so it requires a high durability equal to or higher than that of the other components of the cable 2 (signal lines 24 and the coating 20).

The connection between the cable 2 and the CPU 30 in the PC body 3 will be described below.

Figure 4 shows the connection between the PC body 3 and the cable 2.

Figure 5 shows a connection between the cable 2 and a connection member 34, which is shown by circle (a) in Figure 4.

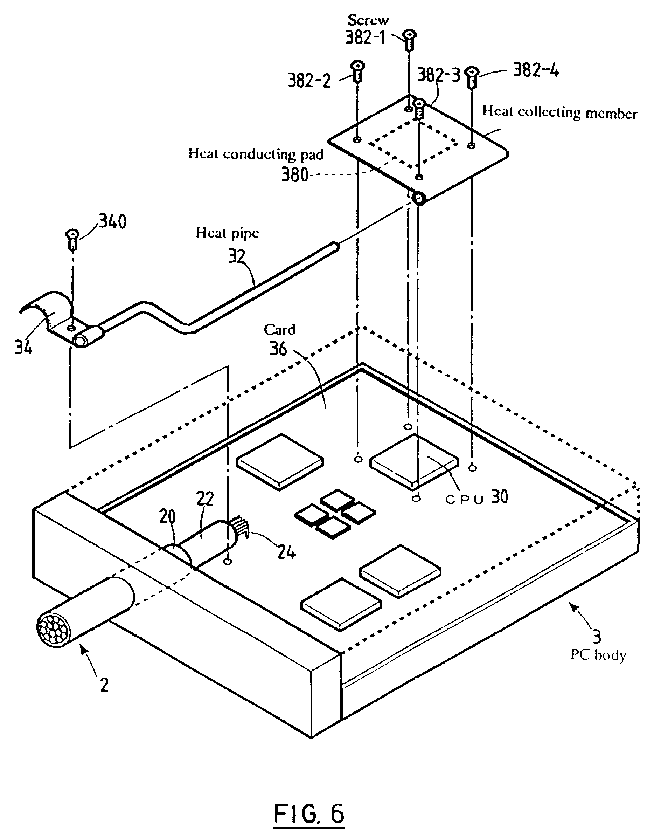

Figure 6 shows a connection between the CPU 30 and a heat collecting member 38, which is shown by circle (b) in Figure 4.

As shown in Figures 4 to 6, the CPU 30 and other parts are disposed in a card 36 inside the PC body 3.

As shown in Figures 4 and 6, the cable 2 is led from the exterior to the interior of the PC body 3, and a coating 20 at the end of the cable 2 is removed to draw out the heat conducting sheet 22 and the conductors 24 as appropriate.

The conductors 24 are further connected to required parts of the card 36.

As shown in Figures 5 and 6, the heat conducting sheet 22 and the conductors 24 are tightened to the card 36 together with the connection member 34 and one end of a heat pipe 32 using a screw. The heat conducting sheet 22, the connection member 34, and the heat pipe 32 are thermally connected together.

For example, a heat conducting pad 380 is provided on a parts side of the heat collecting member 38, as shown in Figure 6. When the heat collecting member 38 is mounted on the card 36 using four screws 382-1 to 382-4, the heat conducting pad 380 is pressed against the top surface of the CPU 30.

In this manner, the heat collecting member 38 and the CPU 30 are thermally connected together via the heat conducting pad 380.

The other end of the heat pipe 32 is guided on the card 36 and locked to the heat collecting member 38 so as to be caulked for thermal connection.

That is, the CPU 30 and the heat conducting sheet 22 of the cable 2 are thermally connected together via the heat collecting member 38, the heat pipe 32, and the connection member 34.

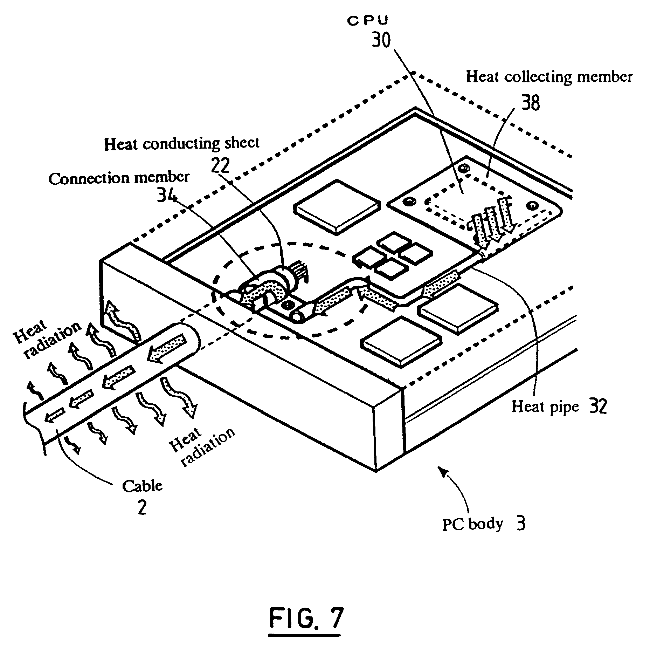

Heat radiation effected by the cable 2 will be described below with reference to Figure 7.

Figure 7 shows heat radiation effected by the cable 2 according to this invention.

As shown by the arrows in Figure 7, heat generated by the CPU 30 inside the PC body 3 is transferred to the heat collecting member 38 and is further transferred to the heat conducting sheet 22 of the cable 2 via the heat pipe 32 and the connection member 34.

The heat conducting sheet 22 conducts in the longitudinal direction of the cable 2, the heat transferred via the heat collecting member 38, the heat pipe 32, and the connection member 34 while gradually releasing the heat to the exterior via the coating 20 to radiate it from the interior of the PC body 3.

The above material of the heat conducting sheet 22 is only an example and may be replaced by another material having a similar heat conductivity and flexibility depending on the application. Instead of graphite, the heat conducting sheet may be, for example, a material comprising a metal having a high heat conductivity (copper or the like) which has been shaped like a sheet or a line.

In addition, the method for connecting the CPU 30 and the heat conducting sheet 22 together which is shown in Figure 4 is only an example, and a different connection method that provides a similar heat conduction effect is applicable depending on the application.

As described above, the cable according to this invention can conduct heat generated in a connected device to the exterior for heat radiation.

In addition, the heat sink according to this invention can use the cable connected to a device for which a radiating means cannot be provided easily in order to conduct heat generated inside this device to the exterior for heat radiation.

In addition, the cable and heat sink according to this invention is suitable for heat radiation from the interior of a portable computer such as a wearable computer effected using the cable that connects the body of the portable computer and a display device and to which the heat conducting member is added.

## Claims

1. A cable capable of radiating heat, comprising:
a heat conducting and radiating member for conducting heat in the longitudinal direction of said cable and radiating the conducted heat.

2. The cable according to Claim 1 comprising:
conductors extending in the longitudinal direction of said cable, wherein;
said heat conducting and radiating member extends in the longitudinal direction of said cable and disposed along said conductors.

3. The cable according to Claim 2, wherein said conductor is a transmission line that transmits signals or power.

4. A cable capable of radiating heat comprising:
conductors extending in the longitudinal direction of said cable;
a heat conducting and radiating member covering the circumference of said conductors to conduct heat in the longitudinal direction of said cable and to radiate the conducted heat; and
a coating covering the circumference of said heat conducting and radiating member.

5. A heat sink comprising:
a cable capable of radiating heat; and
a heat connecting member for thermally connecting a heat generator to said cable capable of radiating heat.

6. The heat sink according to Claim 5, wherein said cable comprises:
conductors extending in the longitudinal direction of said cable;
a heat conducting and radiating member covering the circumference of said conductors to conduct heat in the longitudinal direction of said cable and to radiate the conducted heat; and
a coating covering the circumference of said heat conducting and radiating member.

7. The heat sink according to Claim 5, wherein said cable comprises:
a heat conducting and radiating member for conducting heat in the longitudinal direction of said cable and radiating the conducted heat.

8. The heat sink according to Claim 7, wherein said heat connecting member conducts heat from said heat generator to said heat conducting and radiating member of said cable.

9. The heat sink according to Claim 7 comprising conductors extending in the longitudinal direction of said cable, wherein said heat conducting and radiating member extends in the longitudinal direction of said cable and is disposed along said conductors.

10. The heat sink according to Claim 9, wherein said conductor is a transmission line that transmits signals or power.
